Europäisches Patentamt

European Patent Office

Office européen des brevets

(11) Publication number: **0 212 987**
A2

# EUROPEAN PATENT APPLICATION

(21) Application number: 86306629.6

(22) Date of filing: 27.08.86

(51) Int. Cl.⁴: **H 03 L 7/18**, H 03 K 21/40

(30) Priority: 28.08.85 GB 8521379

(43) Date of publication of application: 04.03.87
Bulletin 87/10

(84) Designated Contracting States: DE FR NL

(71) Applicant: **PLESSEY OVERSEAS LIMITED, Vicarage Lane, Ilford Essex IG1 4AQ (GB)**

(72) Inventor: **Cowley, Nicholas Paul, 10 Summerhouse Road, Wroughton Wiltshire (GB)**

(74) Representative: **Sorenti, Gino, Intellectual Property Department The Plessey Company plc 2-60 Vicarage Lane, Ilford Essex IG1 4AQ (GB)**

(54) Improvements in or relating to prescalers.

(57) A prescaler 2 for a frequency synthesis system comprises a limiter preamplifier 4 coupled to a divider 6. A threshold detector 8 is provided to inhibit operation, and hence possible self oscillation of the divider 6, in the absence of a level of applied signal above a predetermined threshold level.

## IMPROVEMENTS IN OR RELATING TO PRESCALERS

The present invention relates to improvements in or relating to prescalers.

High speed prescalers are used principally in frequency synthesis tuning systems. Such systems include a frequency synthesis loop which consists normally of a high speed prescaler followed by a synthesiser which provides a control voltage for a local oscillator located in the loop. The synthesisers are normally realised in a low speed technology such as metal oxide silicon (MOS) technology and hence, are relatively low frequency devices when compared to the frequency of operation of the local oscillator that may be required to provide a tuning range which, typically, may extend to about 1GHz. The function of the prescaler is to divide the local oscillator frequency to a suitable frequency for the MOS technology synthesiser and also to act as a prescale ratio for the fine tune step of the synthesiser. The fine tune steps and division ratio of the prescaler are usually arranged to provide sensible tuning increments of the local oscillator.

The high speed prescaler will consist normally of an input radio frequency amplifier followed by a cascade of divide by two divider elements. The divide by two divider elements are usualy realised in emitter coupled logic

- 2 -

(ECL) and consist of two latch circuits with feedback loops phase arranged such that they perform a divide by two function.

As a consequence of the circuit design, if the ECL clock inputs are of equal voltage level, as will happen in the first divide by two divider element in the cascade in the absence of an input signal of sufficient level to the radio frequency amplifier, then the first divide by two divider element will oscillate at a frequency determined by the delay time around the feedback loop of the latch circuits.

This oscillation can give rise to a serious problem in frequency synthesis systems as some local oscillators are designed to switch off at extremes of varactor line voltages; which are used to tune the oscillators. If this occurs the frequency synthesis loop will start to self oscillate at the notional resonant frequency of the first divide by two divider element in the cascade. If this frequency is lower than the maximum frequency of the synthesiser the loop thinks it is too low in frequency and hence, tries to drive the voltage on the varactor line higher in order to compensate for the frequency error. However, the voltage on the varactor line will already be at its maximum level. A latch up has, therefore, occured within the loop which cannot be broken unless the frequency synthesis loop is disabled.

Frequency synthesis tuning systems have been proposed which do not self oscillate in the absence of an insufficient level of input signal. However, systems of this type exhibit a marked decrease of input sensitivity at high frequency. As frequency synthesis tuning systems are frequently required to operate at high frequency signals it will be realised that this degradation in input sensitivity is disadvantageous to the system.

It is an intention of the present invention to provide a prescaler, for use in frequency synthesis tuning systems, which does not self oscillate and which does not exhibit a marked decrease in input sensitivity.

Accordingly there is provided a prescaler for a digital synthesiser, the prescaler comprising a threshold detector arranged to provide a control signal in dependence upon a predetermined level of input signal to the prescaler, and a divider arranged to receive a signal dependent upon the control signal such that the prescaler is disabled when the level of input signal is less than or equal to the predetermined level of input signal.

Preferably, the control signal is an inhibit signal and the threshold detector is arranged to provide the inhibit signal when the level of input signal to the prescaler is equal to or less than the predetermined level of of input signal.

Advantageously, the threshold detector comprises a triple long tailed pair transistor circuit in combination with a Schmitt trigger circuit.

The present invention will now be described, by way of example, with reference to the accompanying drawings in which

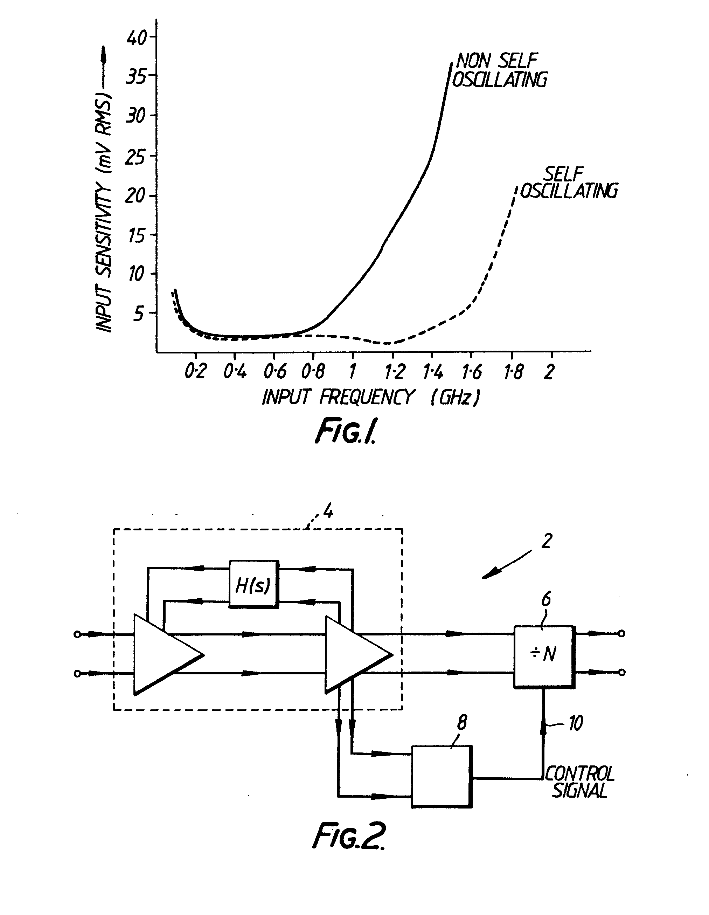

Figure 1 is a graphical representation showing the input sensitivity of self oscillating and non self oscillating types of prescaler against input signal frequency;

Figure 2 illustrates a generally schematic block diagram of a prescaler in accordance with an aspect of the present invention; and,

Figure 3 illustrates a circuit diagram of a threshold detector for use in the prescaler shown in figure 2.

Referring to the drawings, a prescaler 2 comprises a preamplifier limiter 4 for receiving an input signal from the local oscillator of a frequency synthesis tuning system (not shown). The preamplifier limiter 4 is arranged such that it has a sufficiently wide dynamic range that is, the output power of the preamplifier limiter 4 is substantially invariant between two predefined limits of input signal power level. The preamplifier limiter 4 is coupled to a divider 6, the output of which may be coupled to a low speed technology synthesiser (not shown) in the frequency synthesis loop of the tuning system. The preamplifier limiter 4 is also coupled to a threshold detector 8, the output of which is also coupled to the divider 6 by a control line 10. The divider 6 comprises a cascade of divide by two divider elements.

In operation, the output signal of the preamplifier limiter 4, or a signal dependent thereon, drives the clock input of the first divide by two element of the divider 6. This signal is also fed to the threshold detector 8. In order to prevent the divider 6 locking up into self oscillation, as described previously, the threshold detector 8 detects the level of the signal from the preamplifier limiter 4, which signal is dependent upon the level of signal received from the local oscillator of the requency synthesis loop, and provides a control signal to the divider 6 along the control line 10. In the embodiment shown, the control signal enables the divider 6 when the input signal applied to the prescaler 2 reaches a predetermined level. This predetermined level is arranged to ensure that the divider 6 will not lock up into self oscillation. If the level of the input signal to the prescaler 2 falls below the predetermined level the enable control signal is not provided by the threshold detector 8 along the control line 10 and hence the lock up into self oscillation by the divider 6, which would occur if the theshold detector was not present, is prevented.

To prevent the possibility of toggling between the divider being enabled or disabled when the level of the input signal to the prescaler 2 is equal to the predetermined level, the threshold detector 8 is, preferably, arranged to exhibit a degree of hysteresis.

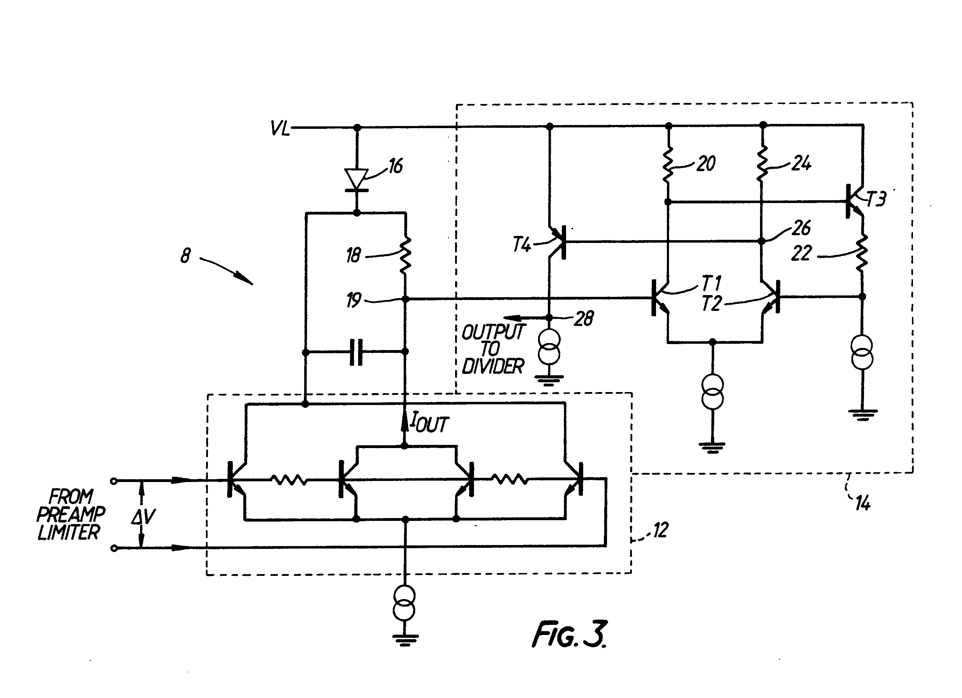

A circuit which may be used as the threshold detector 8 is illustrated in figure 3. Referring to figure 3, the threshold detector 8 comprises a triple long tailed pair transistor circuit 12 in combination with a Schmitt trigger circuit 14. The operation of this configuration of threshold detector 8 is as follows.

Assuming that the level of the signal received by the threshold detector 8 from the preamplifier limiter 4 is V, then the triple long tailed pair transistor circuit 12 will provide an output current Iout which is at a maximum when the input voltage V is at a minimum. When this condition prevails, that is when the level of input signal to the prescaler 2 is such that lock up into self oscillation of the divider 6 would be experienced, the maximum value for the output current Iout will provide a maximum drop of line voltage $V_L$ across a diode 16 and an associated series resistor 18. The voltage at a node 19 will therefore be at a minimum and hence, the base voltage of a transistor T1 of the Schmitt trigger 14 is at a minimum. Transistor T1 is, therefore, biased off. As the level of the input voltage V increases, with an increase in level of input signal to the prescaler 2, the output current Iout decreases and hence, the voltage at the node 19 rises towards the line voltage VL. The voltage on the base of the transistor T1, which is coupled directly to the node 19, also rises and, when a threshold level is reached, the transistor T1 starts to conduct. When transistor T1 conducts the voltage on the base of transistor 2 falls which, in view of the positive feedback loop provided by resistors 20, 22 and transistor T3, causes an increase in conduction of transistor T1 which in turn causes a further drop in the voltage on the base of transistor T2 until transistor T1 is biased fully ON and the transistor T2 is biased OFF.

The voltage drop across resistor 24 decreases with the drop in voltage at the base of transistor T2 which causes the voltage on the base of transistor T4 to rise with transistor T2 biased OFF the voltage at node 26 is almost equal to the line voltage VL and hence transistor T4 is biased OFF. This causes the voltage at output 28 to fall, which enables the divider 6 of the prescaler 2.

The positive feedback loop provided by the resistors 20, 22 and transistor T3 produces hysteresis in the response of the threshold detector 8 which inhibits toggling of the output 28 between enable and disable modes when the level of the input signal to the triple long tailed pair transistor circuit 12 is equal to the threshold level of the threshold detector 8.

Such hysteresis arises because when the transistor T1 is biased on, the comparison voltage on the base of transistor T2 has fallen by the voltage drop across the resistor 20. Hence, the voltage on the base of the transistor T1, when biased ON must also fall by a voltage corresponding to the voltage drop across resistor 20 before the transistors T1 and T2 return to their initial states with transistor T1 OFF and transistor T2 ON.

The output current I out of the triple long tailed pair transistor circuit 12 may decrease with an increase in the frequency of the input signal to above 1 GHz. This non linear response of the triple long tailed pair transistor circuit 12 may be compensated by providing the preamplifier limiter 4 with a gain characteristic which increases with frequency, as is known in the art.

Although the present invention has been described with respect to a particular embodiment, it should be realised that modifications may be effected within the scope of the invention for example, the threshold detector may be arranged to provide a control signal in the form of an inhibit signal to disable the divider 6 when the level of input signal is below the predetermined level.

Furthermore, the divider 6 may not comprise a cascade of divide by two divider elements. Other forms of divider may be used. Additionally, the prescaler may form part of a digital synthesiser and may include an output stage for coupling to subsequent sections of the digital synthesiser. The control signal from the threshold detector may also be used to control the operation of the output stage of the prescaler. This may be achieved by disabling and selecting a predetermined state for the output stage in the absence of an input signal to the threshold detector in excess of the predetermined level of input signal.

The prescaler of the present invention or a digital synthesiser incorporating such a prescaler, may be fabricated as an integrated circuit device.

0212987

- 10 -

<u>CLAIMS</u>

1.   A prescaler (2) for a digital synthesiser, the prescaler (2) characterised by a threshold detector (8) arranged to provide a control signal in dependence upon a predetermined level of input signal to the prescaler (2), and a divider (6) arranged to receive a signal dependent upon the control signal such that the prescaler (2) is disabled when the level of input signal is less than or equal to the predetermined level of input signal.

2.   A prescaler (2) according to claim 1 characterised in that the control signal is an inhibit signal and the threshold detector (2) is arranged to provide the inhibit signal when the level of input signal to the prescaler (2) is equal to or less than the predetermined level of input signal.

3.   A prescaler (2) according to claim 1 characterised in that the control signal is an enable signal and the threshold detector (2) is arranged to provide the enable signal when the level of input signal to the prescaler (2) is equal to or greater than the predetermined level of input signal.

4. A prescaler (2) according to any one of claims 1, 2 or 3 characterised by a preamplifier (4) arranged to receive the input signal to the prescaler (2) and the threshold detector (8) is coupled to the output of the preamplifier (4).

5. A prescaler (2) according to any one of the preceding claims wherein the divider (6) comprises a cascade of divide by two divider elements.

6. A prescaler (2) according to claim 5 wherein each divide by two divider element comprises a pair of latch circuits, each latch circuit having a feedback loop, and wherein the latch circuits are phase arranged to provide a divide by two function.

7. A prescaler (2) according to any one of the preceding claims wherein the threshold detector (8) is arranged to exhibit a hysteresis response characteristic whereby, when the level of the input signal to the threshold detector (8) is substantially equal to the predetermined level of input signal, toggling of the output of the threshold detector (2) is obviated.

8. A prescaler (2) according to claim 7 wherein the threshold detector (8) comprises a triple long tailed pair transistor circuit (12) in combination with a Schmitt trigger circuit (14).

9. A prescaler (2) according to any one of the preceding claims further comprosing an output stage, arranged to receive the control signal from the threshold detector (8) whereby the output stage of the prescaler (2) is controlled in dependence upon the control signal from the threshold detector.

10. A prescaler (2) according to claim 9 wherein the output stage is arranged to be disabled and switched into a predetermined state by the control signal from the threshold detector (8) in the absence of an input signal to the threshold detector (8) in excess of the predetermined level of input signal.

11. A digital synthesiser comprising a prescaler (2) according to any one of the preceding claims.

12. An integrated circuit device comprising a prescaler (2) according to any one of claims 1 to 8 or a digital synthesiser according to claim 11.

0212987

1/2

FIG.1.

FIG.2.

Fig.3

VL

FROM PREAMP LIMITER

ΔV

I_OUT

OUTPUT TO DIVIDER

T1 T2 T3 T4

8  12  14  16  18  19  20  22  24  26  28